# EUROPÄISCHE PATENTSCHRIFT

(11) **EP 4 168 603 B1**
(45) Veröffentlichungstag und Bekanntmachung des Hinweises auf die Patenterteilung: **07.08.2024**
(21) Anmeldenummer: 21733111.5
(22) Anmeldetag: 16.06.2021
(51) Int. Cl.: C23C 14/12, C23C 14/24, C23C 16/448, C23C 14/54, C23C 16/455, B01D 1/00, B01D 1/14, G05D 11/13

(54) **VORRICHTUNG UND VERFAHREN ZUM VERDAMPFEN EINES ORGANISCHEN PULVERS**
DEVICE AND METHOD FOR EVAPORATING AN ORGANIC POWDER
DISPOSITIF ET PROCÉDÉ POUR L'ÉVAPORATION D'UNE POUDRE ORGANIQUE

(30) Priorität: 19.06.2020 DE 102020116271
(43) Veröffentlichungstag der Anmeldung: 26.04.2023
(73) Patentinhaber: AIXTRON SE, 52134 Herzogenrath (DE)
(72) Erfinder: JAKOB, Markus, 52156 Monschau (DE); EICHLER, Andy, 52080 Aachen (DE)
(74) Vertreter: Grundmann, Dirk
(86) Internationale Anmeldenummer: PCT/EP2021/066210
(87) Internationale Veröffentlichungsnummer: WO 2021/255078

(56) Entgegenhaltungen:
- DE-A1- 102014 102 484
- DE-A1- 102017 103 047
- DE-A1- 102017 126 126
- JP-A- 2010 278 167
- KR-B1- 101 140 145
- US-A1- 2004 007 180
- US-A1- 2006 062 919
- US-A1- 2017 101 715
- US-A1- 2019 085 444
- US-A1- 2019 161 863
- US-B2- 10 655 220
- US-B2- 10 718 050

## Beschreibung

### Gebiet der Technik

Die Erfindung betrifft ein Verfahren zum Verdampfen eines nicht gasförmigen Ausgangsmaterials, bei dem ein nicht gasförmiges Ausgangsmaterial in eine Verdampfungskammer eines Verdampfer gebracht wird, ein Verdampfungskörper des Verdampfers dem Ausgangsmaterial Wärme zuführt, sodass es zu einem Dampf verdampft, der Dampf mittels eines durch eine Gaszuleitung in die Verdampfungskammer eingespeisten Fördergasstroms, dessen Massenfluss von einem ersten Massenflusskontroller geregelt wird, durch einen Förderkanal an einem QCM-Sensor vorbeitransportiert wird, der die Konzentration oder den Partialdruck des Dampfs im durch den Förderkanal fließenden Gasstrom misst, und der Massenfluss des Dampfes durch den Förderkanal durch Variation des Fördergasstroms gegen einen Sollwert geregelt wird.

Die Erfindung betrifft darüber hinaus eine Vorrichtung zum Verdampfen eines nicht gasförmigen Ausgangsmaterials, mit einem Verdampfer, der eine Verdampfungskammer und einen beheizbaren Verdampfungskörper aufweist, mit dem das in die Verdampfungskammer gebrachte Ausgangsmaterial zu einem Dampf verdampft wird, mit einer in die Verdampfungskammer mündenden, einen ersten Massenflusskontroller aufweisenden Gaszuleitung zum Einspeisen eines Fördergasstroms in die Verdampfungskammer mit einem von der Verdampfungskammer ausgehenden Förderkanal zum Transport des Dampfes mit dem Fördergasstrom an einem im Förderkanal angeordneten QCM-Sensor vorbei, der die Konzentration oder den Partialdruck des Dampfes im durch den Förderkanal fließenden Gasstrom misst, und mit einer Regeleinrichtung zur Regelung des Massenflusses des Dampfes durch den Förderkanal gegen einen Sollwert durch Variation des Fördergasstroms.

### Stand der Technik

Eine Vorrichtung oder ein Verfahren der gattungsgemäßen Art wird in der DE 10 2014 102 484 A1 beschrieben. Ein Aerosolerzeuger erzeugt ein Aerosol, das in einen Verdampfungskörper geleitet wird. ein Trägergas wird zusätzlich in den Verdampfungskörper eingespeist. Mit einem stromabwärts des Verdampfungskörpers angeordneten QCM-Sensor kann der Partialdruck des Dampfs in einer Zuleitung zu eine OLED-Reaktor gemessen werden. Die Förderrate des Aerosols bzw. die Massenflussrate des Trägergases wird so eingestellt, dass das Sensorsignal des QCM-Sensors auf einem konstanten Wert gehalten wird.

Die US 2019/0161863 A1 und die US 2017/01001715 A1 beschreiben eine Vorrichtung zum Verdampfen einer Flüssigkeit und Bereitstellen eines mit dem Dampf der Flüssigkeit angereicherten Trägergasstrom. Hierzu soll ein mit einem ersten Massenflussmesser geregelter Massenfluss des Trägergases in den die Flüssigkeit beinhaltenden Behälter eingespeist werden. In eine Ableitung, in der sich ein Sensor befindet, kann ein Verdünnungsgas eingespeist werden, dessen Massenfluss mit einem zweiten Massenflussregler gesteuert werden kann. Mit dem ersten Massenflussregler kann die Dampftransportmenge eingestellt werden. mit dem Verdünnungsgas kann der Massenfluss des Gases in der Ableitung auf einem konstanten Wert gehalten werden. Mit dem Sensor wird der Partialdruck des Dampfes in der Ableitung auf einem konstanten Wert gehalten.

Bei einer gattungsgemäßen Vorrichtung bzw. einem gattungsgemäßen Verdampfer wird die Verdampfungsrate im Verdampfer zum einen durch die Temperatur des Verdampfungskörpers und zum anderen durch die mittlere Korngröße des Pulvers beeinflusst. Zeitliche Variationen der Verdampfung im Verdampfer werden mit dem Ziel, einen möglichst konstanten Massenfluss des Dampfes zum Reaktor zu gewährleisten, durch eine Änderung der Strömungsgeschwindigkeit im Förderkanal ausgeglichen. Dies erfolgt über einen PID-Regler, der auf den ersten Massenflusskontroller wirkt. Es wurde beobachtet, dass das Messverhalten des Sensors von der Strömungsgeschwindigkeit des Gases durch den Förderkanal beeinflusst wird.

Um aus der Depositionsrate des Dampfes auf der Depositionsfläche des Sensors Werte für die Konzentration oder den Partialdruck des Dampfes im Fördergasstrom zu berechnen, wird ein "tooling factor" verwendet, der gasflussabhängig ist. Bei sich änderndem Gasfluss kommt es daher zu verfälschten Messwerten.

Zum Stand der Technik gehören ferner die US 2017/362701 A1, KR 101179872 B1, US 9,302,291 B2, EP 1167 569 A1 und WO 2017/027581 A1.

### Zusammenfassung der Erfindung

Der Erfindung liegt die Aufgabe zugrunde, Maßnahmen anzugeben, mit denen in einer gattungsgemäßen Vorrichtung beziehungsweise bei einem gattungsgemäßen Verfahren die Förderrate des Dampfes in einem höheren Maße konstant gehalten werden kann, um in einem OLED-Reaktor Schichten mit einer geringen bis mittleren Wachstumsrate mit reproduzierbarer Schichtdicke abzuscheiden.

Gelöst wird die Aufgabe durch die in den Ansprüchen 1 und 2 angegebene Erfindung.

Zunächst und im Wesentlichen wird die Aufgabe dadurch gelöst, dass an einer Mischstelle im Förderkanal, die zwischen dem Verdampfer und dem Sensor liegt, ein Ausgleichsgasstrom in den Förderkanal eingespeist wird. Der Ausgleichsgasstrom wird von einer Ausgleichsgaszuleitung bereitgestellt, in der sich ein zweiter Massenflusskontroller befindet. Der zweite Massenflusskontroller wird so geregelt, dass der Gesamtgasfluss des Mediums, das am Sensor vorbeifließt, auch bei einer Variation des Fördergasstroms konstant gehalten wird. Es ist insbesondere vorgesehen, dass der Ausgleichsgasstrom derart geregelt wird, dass am Sensor ein den Dampf fördernder Gasstrom mit einer konstanten Strömungsgeschwindigkeit vorbeifließt. Hierzu ist insbesondere vorgesehen, dass der durch die Ausgleichsgaszuleitung fließende Gasstrom um den Massenfluss verringert wird, um den der durch die Fördergaszuleitung strömende Massenfluss erhöht wird und umgekehrt. Die Massenflusskontroller werden erfindungsgemäß somit im Gegentakt betrieben. Die Summe der Massenflüsse bleibt innerhalb einer Toleranz der Massenflusskontroller von beispielsweise +/-2 Prozent während des gesamten Abscheidungsprozesses konstant. Hierdurch wird die Flussratenstabilität des Dampfes zum Gaseinlassorgan des OLED-Reaktors gegenüber dem Stand der Technik erhöht. Die erfindungsgemäß erreichte Verbesserung der Ratenstabilität der Verdampfungsquelle tritt insbesondere für kleine Verdampfungsraten auf. An der bewährten Technologie des Standes der Technik, den festen oder flüssigen Ausgangsstoff durch eine feste Verdampfertemperatur zu verdampfen und die Flussrate durch einen einstellbaren Trägergasfluss zu stabilisieren, kann festgehalten werden. Der hinsichtlich seines Massenflusses des Trägergases variierende Fördergasstrom wird mittels eines Ausgleichsgasstroms derart verdünnt, dass der Gesamtmassenfluss des Trägergases, der am Sensor vorbeifließt, konstant gehalten wird. Der Fördergasfluss und der Ausgleichsgasfluss können von derselben Gasquelle, beispielsweise einer Stickstoff-Quelle, bereitgestellt werden. Dies hat den Vorteil, dass der Sensor, der bevorzugt ein Quarz-Kristall-Monitor (QCM) ist, mit einem nur für eine Strömungsgeschwindigkeit ermittelten tooling factor betrieben werden kann. Mit einer PID-Regeleinrichtung können mithilfe der vom Sensor gelieferten Messwerte zwei Massenflüsse, die in den Förderkanal eingespeist werden, derart geregelt werden, dass eine Dampftransportrate zeitlich konstantgehalten wird. Der erzeugte Dampf wird durch eine beheizte Transportleitung zu einem OLED-Reaktor transportiert, in dem sich ein Substrat, beispielsweise ein Glassubstrat, befinden kann, welches mit ein oder mehreren organischen Schichten beschichtet wird. Hierzu wird der durch den Förderkanal geförderte Dampf in ein Gaseinlassorgan eingespeist, welches eine Vielzahl zu einer Prozesskammer weisende Gasaustrittsöffnungen aufweist, durch die der vom Trägergas transportierte Dampf in die Prozesskammer des Reaktors eingeleitet wird, sodass der Dampf auf dem auf einem gekühlten Substrathalter liegenden Substrat kondensieren kann. Hinsichtlich der Ausgestaltung des Verdampfers wird auf die Ausführungen in der DE 10 2020 103 822 verwiesen. Eine Reaktoranordnung mit Verdampfungsquelle zeigt beispielsweise die Figur 3 der DE 10 2019 128 515 oder der DE 10 2017 106 431 A1. Der Inhalt der Anmeldungen wird in den Offenbarungsgehalt dieser Anmeldung mit eingeschlossen.

### Kurze Beschreibung der Zeichnungen

Ein Ausführungsbeispiel der Erfindung wird nachfolgend anhand der beigefügten Figur beschrieben.

### Beschreibung der Ausführungsformen

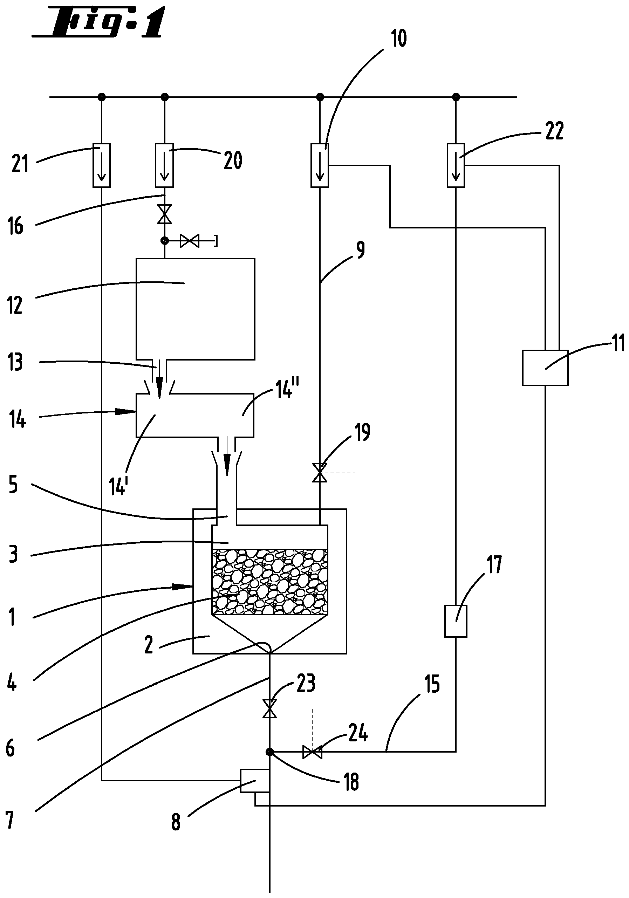

Die Figur 1 zeigt schematisch eine Dampfquelle, die eine Dosiervorrichtung 12 zum Bereitstellen eines zu verdampfenden festen oder flüssigen Ausgangsstoffs, der über einen Zwischenspeicher 14 in eine Verdampfungskammer 3 eines Verdampfers eingespeist wird, wo der Ausgangsstoff verdampft, um mittels eines Fördergasstroms durch einen Förderkanal 7 zu einem nicht dargestellten OLED-Reaktor transportiert zu werden.

Das in der Figur 1 dargestellte System zeigt eine Dosiervorrichtung 12, die einen Vorratsbehälter besitzen kann, in dem ein Pulver eines organischen Materials bevorratet wird. Das Pulver kann beispielsweise über ein Dosierrad mit einer Vielzahl von Dosierkammern zu einer Abgabestelle transportiert werden. Die Dosierkammern können von kreisförmig um eine Drehachse angeordneten Löchern einer flachen Scheibe gebildet sein. Während der Drehung der flachen Scheibe füllen sich die zu den beiden Breitseiten der Scheibe hin offenen Löcher mit dem Pulver. An der Abgabestelle bläst ein Trägergasstrom durch eines dieser Löcher und transportiert die darin enthaltene quantifizierte Menge des Pulvers in eine Ableitung, an die sich eine Förderstrecke anschließt, mit der eine Vielzahl von nacheinander in den Trägergasstrom gebrachten Pulvermengen zu einem Zwischenspeicher 14 transportiert wird.

Die Rate des transportierten Pulvers wird durch die Drehzahl des Dosierrades vorgegeben. Über die Zeit, innerhalb der Pulver bei gleicher Drehzahl des Dosierrades dem Zwischenspeicher 14 zugeführt wird, kann die dem Zwischenspeicher zugeführte Pulvermenge bestimmt werden. Es ist aber auch möglich, andere Dosiereinrichtungen zu verwenden, die das dosierte Pulver entweder als Aerosol oder nicht als Aerosol in Richtung einer Verdampfungskammer 3 eines Verdampfers 1 fördern. Zur Förderung des Aerosols kann durch eine Gaszuleitung 16 ein Trägergas in die Dosiervorrichtung 12 eingespeist werden, dessen Massenfluss mittels eines Massenflusskontrollers 20 geregelt werden kann.

Der optionale Zwischenspeicher 14 kann einen Auffangbehälter aufweisen, der in einem kalten Bereich 14' des Zwischenspeichers 14 kontinuierlich befüllt wird. Der Auffangbehälter kann in regelmäßigen oder unregelmäßigen Abständen zu einem heißen Bereich 14" des Zwischenspeichers 14 gebracht werden, um dort entleert zu werden. Der Inhalt des Auffangbehälters wird dabei mittels eines Gasstroms durch eine Einspeiseöffnung 5 in den Verdampfer 1 gefördert. Die Temperatur im heißen Bereich 14" des Zwischenspeichers 14 kann oberhalb der Verdampfungstemperatur des Ausgangsstoffs liegen. Es ist aber auch möglich, den Ausgangsstoff direkt von der Dosiervorrichtung 12 in den Verdampfer 1 einzuspeisen.

Der Verdampfer 1 besitzt eine erste Einspeiseöffnung 5, durch die der Ausgangsstoff mit oder ohne Trägergas in die Verdampfungskammer 3 des Verdampfers 1 gefördert wird. Der Verdampfer 1 besitzt eine zweite Einspeiseöffnung. Durch die zweite Einspeiseöffnung kann ein durch eine Gaszuleitung 9 strömender Fördergasstrom in den Verdampfer 1 eingespeist werden. Der Fördergasstrom wird von einem Massenflusskontroller 10 geregelt. In der Gaszuleitung 9 befindet sich darüber hinaus ein Ventil 19.

Der Ausgangsstoff wird in Form von festen oder flüssigen Partikeln, die Teil eines Aerosols sind, in die Verdampfungskammer 3 eingespeist. Die Partikel verteilen sich innerhalb des Verdampfungskörpers 4 unregelmäßig und können sich an den Oberflächen des Verdampfungskörpers 4 in unregelmäßiger Materialstärke anlagern.

Der Verdampfer 1 besitzt eine Heizeinrichtung 2, mit der ein in der Verdampfungskammer 3 angeordneter Verdampfungskörper 4 auf eine Temperatur gebracht wird, bei der der in den Verdampfungskörper 4 eingespeiste Ausgangsstoff verdampfen kann. Der Verdampfungskörper 4 kann ein aus einem elektrisch leitenden Material bestehender Festkörperschaum sein. Durch Hindurchleiten eines elektrischen Stroms durch den Verdampfungskörper 4 kann diesem Energie zugeführt werden, mit der die Verdampfung des Ausgangsstoffs bewirkt wird. Der dabei entstehende Dampf wird mit dem Fördergasstrom zu einer Austrittsöffnung 6 des Verdampfers 1 transportiert, wo ein Förderkanal 7 entspringt, durch den der Dampf zu dem nicht dargestellten OLED-Reaktor transportiert wird.

Die Verdampfungsrate, mit der der Ausgangsstoff verdampft wird, hängt zum einen von der Verteilung der Partikel auf den Oberflächen des Verdampfungskörpers 4 und zum anderen von der jeweiligen Materialstärke einer von zu verdampfenden Partikeln ausgebildeten Schicht auf den Oberflächen und darüber hinaus von den Partikelgrößen des Ausgangsstoffs ab. Da sich durch die stetige Verdampfung die Verteilung der Partikel und die Schichtdicken von an den Oberflächen angelagerten Partikeln stetig ändert, unterliegt die Verdampfungsrate Schwankungen.

Mit der Bezugsziffer 8 ist ein QCM-Sensor bezeichnet, an dem der den Dampf und das Trägergas des Fördergasstroms beinhaltender Gasfluss vorbeiströmt. Mit dem Sensor 8 kann die Konzentration beziehungsweise der Partialdruck des Dampfes innerhalb des Gasflusses bestimmt werden. Hierzu besitzt der Sensor 8 eine Depositionsfläche, die auf einer Temperatur unterhalb der Kondensationstemperatur des Dampfes gehalten wird, sodass auf der Depositionsfläche Kondensat abgeschieden wird. Die Abscheiderate wird von der Konzentration beziehungsweise dem Partialdruck des Dampfes innerhalb des Förderkanals 7 beeinflusst. Über einen tooling factor beziehungsweise eine Kalibrierfunktion kann aus der Abscheiderate direkt die Konzentration beziehungsweise der Partialdruck des Dampfes ermittelt werden. Ein Gasstrom, der mit dem Massenflusskontroller 21 geregelt wird, kann beispielsweise zu Wartungszwecken oder zu Reinigungszwecken in den QCM-Sensor 8 eingespeist werden.

Aufgrund der schwankenden Verdampfungsrate würde der QCM-Sensor 8 bei einem konstant gehaltenen Fördergasstrom einen zeitlich stark variierenden Partialdruck des Dampfes im Gasstrom messen.

Es ist eine Regeleinrichtung 11 vorgesehen, mit der der Massenfluss des Dampfes innerhalb des Förderkanals 7 variiert werden kann, um so den Massenfluss des Dampfes innerhalb des Förderkanals 7 gegen einen Sollwert zu regeln. Hierzu wird der Massenflusskontroller 10 innerhalb der Gaszuleitung 9 angesteuert, um den Fördergasstrom zu variieren. Mit diesen Maßnahmen kann die starke Variation des Partialdrucks des Dampfes vermindert werden. Allerdings würde sich mit allein dieser Maßnahme auch der Gesamtfluss des am Sensor 8 vorbeiströmenden Gases ändern, was als nachteilig angesehen wird, da der Sensor nur auf eine Strömungsgeschwindigkeit kalibriert ist.

Mit einem Massenflusskontroller 22, der bevorzugt von derselben Gasquelle gespeist wird, von der auch die Massenflusskontroller 21, 22 und 10 gespeist werden, wird ein Ausgleichsgas bereitgestellt, welches durch eine Ausgleichsgaszuleitung 15 in den Förderkanal 7 eingespeist wird. In der Ausgleichsgaszuleitung 15 befindet sich eine Heizeinrichtung 17, um das Ausgleichsgas auf dieselbe Temperatur aufzuheizen, auf die der Förderkanal 7 mit einer nicht dargestellten Heizeinrichtung beheizt wird. Mit den Bezugsziffern 23 und 24 sind Ventile bezeichnet, die sich im Förderkanal 7 beziehungsweise in der Ausgleichsgaszuleitung 15 befinden.

Die Mischstelle 18, an der die Ausgleichsgaszuleitung 15 in den Förderkanal 7 mündet, befindet sich zwischen der Austrittsöffnung 6 und dem Sensor 8. Sie befindet sich stromaufwärts des Sensors 8.

Mit der Regeleinrichtung 11 wird der Massenflusskontroller 22 derart angesteuert, dass die Summe der Massenflüsse, die durch die Massenflusskontroller 10 und 22 fließen, konstant bleibt. Dies hat die gewünschte Folge, dass die Strömungsgeschwindigkeit des am Sensor 8 vorbeifließenden Gasstroms konstant bleibt. Eine zur Regelung des Massenflusses des Dampfes durch den Förderkanal 7 gegen einen Sollwert erfolgende Variation des Fördergasstroms in die eine Richtung, also beispielsweise eine Erhöhung, hat dieselbe, aber entgegengerichtete Variation des Ausgleichsgasstroms, beispielsweise eine Verminderung, zur Folge.

Mittels der Regeleinrichtung 11 und der von ihr angesteuerten Massenflusskontrollern 22, 10 kann der durch den Förderkanal 7 geförderte Dampf eine gleichbleibende Dampfrate, Dampfkonzentration oder dergleichen aufweisen, wobei auch der Massenfluss des Trägergases innerhalb der Toleranzen konstantgehalten wird. Der Sensor 8 arbeitet bei der erfindungsgemäßen Maßnahme mit einer höheren Messgenauigkeit, da die Konzentrationen beziehungsweise Partialdrucke des Dampfes bei der Strömungsgeschwindigkeit ermittelt werden, bei der der Sensor kalibriert worden ist.

Die vorstehenden Ausführungen dienen der Erläuterung der von der Anmeldung insgesamt erfassten Erfindungen, die den Stand der Technik zumindest durch die folgenden Merkmalskombinationen jeweils auch eigenständig weiterbilden, wobei zwei, mehrere oder alle dieser Merkmalskombinationen auch kombiniert sein können, nämlich:

Ein Verfahren, das dadurch gekennzeichnet ist, dass an einer zwischen Verdampfer 1 und Sensor 8 angeordneten Mischstelle 18 ein Ausgleichsgasstrom in den Förderkanal 7 eingespeist wird, dessen Massenfluss von einem zweiten Massenflusskontroller 22 so geregelt wird, dass bei der Variation des Fördergasstroms der am Sensor 8 vorbeiströmende Gasstrom konstant bleibt.

Eine Vorrichtung, die dadurch gekennzeichnet ist, dass an einer zwischen Verdampfer 1 und Sensor 8 angeordneten Mischstelle 18 eine einen zweiten Massenflusskontroller 22 aufweisende Ausgleichsgaszuleitung 15 mündet und die Regeleinrichtung 11 eingerichtet ist, den zweiten Massenflusskontroller 22 derart anzusteuern, dass bei der Variation des Fördergasstroms der am Sensor 8 vorbeiströmende Gasstrom konstant bleibt.

Ein Verfahren oder eine Vorrichtung, die dadurch gekennzeichnet sind, dass der Sensor 8, an dem der Gasstrom mit einer konstanten Strömungsgeschwindigkeit vorbeiströmt, eine Depositionsfläche aufweist, auf der der Dampf in einer vom Partialdruck oder der Konzentration abhängigen Rate kondensiert.

Ein Verfahren oder eine Vorrichtung, die dadurch gekennzeichnet sind, dass die Summe der mit dem ersten Massenflusskontroller 10 und mit dem zweiten Massenflusskontroller 22 geregelten Massen-Flüsse mit einer Toleranz der Regelgenauigkeit der Massenflusskontroller konstant gehalten wird.

Ein Verfahren oder eine Vorrichtung, die gekennzeichnet ist durch eine Dosiervorrichtung 12, mit der aus einem Vorrat des Ausgangsmaterials eine abgemessene Menge an den Verdampfer 1 abgebbar ist.

Ein Verfahren oder eine Vorrichtung, die dadurch gekennzeichnet sind, dass das Ausgangsmaterial ein organisches Pulver ist und/oder dass der Sensor ein QCM-Sensor ist und/ oder dass der Verdampfungskörper 4 ein offenporiger Festkörperschaum ist und/oder dass der Fördergasstrom und der Ausgleichsgasstrom von einer Inertgasquelle bereitgestellt werden.

Ein Verfahren, das dadurch gekennzeichnet ist, dass mit dem erzeugten Dampf organische Schichten oder OLED-Schichten auf einem Substrat abgeschieden werden.

Eine Vorrichtung, die dadurch gekennzeichnet ist, dass der Förderkanal 7 in einem Gaseinlassorgan eines Reaktors mündet, der eine Prozesskammer aufweist, in der organische Schichten oder OLED-Schichten auf einem Substrat abgeschieden werden können.

Ein Verfahren oder eine Vorrichtung, die dadurch gekennzeichnet sind, dass zwischen der Dosiervorrichtung 12 und dem Verdampfer 1 ein Zwischenspeicher 14 zum Zwischenspeichern der abgemessenen Pulvermenge vorgesehen ist.

Ein Verfahren oder eine Vorrichtung, die dadurch gekennzeichnet sind, dass der Zwischenspeicher 14 einen kalten Bereich 14' aufweist, in dem die mit der Dosiervorrichtung 12 abgemessene Menge des Ausgangsstoffs zwischengespeichert wird, und einen heißen Bereich 14" aufweist, in dem die abgemessene Menge des Pulvers gebracht wird, um durch eine Einspeiseöffnung 5 dem Verdampfer 1 zugeführt zu werden und/oder dass in der Dosiervorrichtung 12 eine Vorrichtung zur Bereitstellung einer quantifizierten Menge des Ausgangsmaterials angeordnet ist, wobei eine Vielzahl von quantifizierten Mengen zeitlich nacheinander in einem von einer Gaszuleitung 16 bereitgestellten Trägergasfluss gebracht werden, mit dem die quantifizierten Mengen als Aerosol-Fluss zum Zwischenspeicher 14 transportiert werden.

Alle offenbarten Merkmale sind (für sich, aber auch in Kombination untereinander) erfindungswesentlich. jedem Anspruch angegebene Erfindung kann zusätzlich ein oder mehrere der in der vorstehenden Beschreibung, insbesondere mit Bezugsziffern versehene und/oder in der Bezugsziffernliste angegebene Merkmale aufweisen. Die Erfindung betrifft auch Gestaltungsformen, bei denen einzelne der in der vorstehenden Beschreibung genannten Merkmale nicht verwirklicht sind, insbesondere soweit sie erkennbar für den jeweiligen Verwendungszweck entbehrlich sind oder durch andere technisch gleichwirkende Mittel ersetzt werden können.

### Liste der Bezugszeichen

- 1: Verdampfer
- 2: Heizeinrichtung
- 3: Verdampfungskammer
- 4: Verdampfungskörper
- 5: Einspeiseöffnung
- 6: Austrittsöffnung
- 7: Förderkanal
- 8: Sensor
- 9: Gaszuleitung
- 10: Massenflusskontroller
- 11: Regeleinrichtung
- 12: Dosiervorrichtung
- 13: Förderstrecke
- 14: Zwischenspeicher
- 14': kalter Bereich
- 14": heißer Bereich
- 15: Ausgleichsgaszuleitung
- 16: Gaszuleitung
- 17: Heizeinrichtung
- 18: Mischstelle
- 19: Ventil
- 20: Massenflusskontroller
- 21: Massenflusskontroller
- 22: Massenflusskontroller
- 23: Ventil
- 24: Ventil

## Patentansprüche

1. Verfahren zum Verdampfen eines nicht gasförmigen Ausgangsmaterials, bei dem das Ausgangsmaterial in eine Verdampfungskammer (3) eines Verdampfer (1) gebracht wird, ein Verdampfungskörper (4) des Verdampfers (1) dem Ausgangsmaterial Wärme zuführt, sodass es zu einem Dampf verdampft, der Dampf mittels eines durch eine Gaszuleitung (9) in die Verdampfungskammer (3) eingespeisten Fördergasstroms, dessen Massenfluss von einem ersten Massenflusskontroller (10) geregelt wird, durch einen Förderkanal (7) an einer Depositionsfläche eines QCM-Sensors (8) vorbeitransportiert wird, der die Konzentration oder den Partialdruck des Dampfs im durch den Förderkanal (7) fließenden Gasstrom derart misst, dass der Dampf in einer vom Partialdruck oder der Konzentration abhängigen Rate auf der Despositionsfläche kondensiert und der Massenfluss des Dampfes durch den Förderkanal (7) durch Variation des Fördergasstroms gegen einen Sollwert geregelt wird, **dadurch gekennzeichnet, dass** an einer zwischen Verdampfer (1) und Sensor (8) angeordneten Mischstelle (18) ein Ausgleichsgasstrom in den Förderkanal (7) eingespeist wird, dessen Massenfluss von einem zweiten Massenflusskontroller (22) so geregelt wird, dass bei der Variation des Fördergasstroms der am Sensor (8) vorbeiströmende Gasstrom konstant bleibt und mit einer konstanten Strömungsgeschwindigkeit an der Depositionsfläche vorbeiströmt.

2. Vorrichtung zum Verdampfen eines nicht gasförmigen Ausgangsmaterials, mit einem Verdampfer (1), der eine Verdampfungskammer (3) und einen beheizbaren Verdampfungskörper (4) aufweist, mit dem das in die Verdampfungskammer (3) gebrachte Ausgangsmaterial zu einem Dampf verdampft wird, mit einer in die Verdampfungskammer (3) mündenden, einen ersten Massenflusskontroller aufweisenden Gaszuleitung zum Einspeisen eines Fördergasstroms in die Verdampfungskammer (3) mit einem von der Verdampfungskammer (3) ausgehenden Förderkanal (7) zum Transport des Dampfes mit dem Fördergasstrom an einem im Förderkanal (7) angeordneten Sensor (8), eine Depositionsfläche aufweisenden QCM-Sensor (8) vorbei, der die Konzentration oder den Partialdruck des Dampfes im durch den Förderkanal (7) fließenden Gasstrom derart misst, dass der Dampf in einer vom Partialdruck oder der Konzentration abhängigen Rate auf der Depositionsfläche kondensiert misst und mit einer Regeleinrichtung (11) zur Regelung des Massenflusses des Dampfes durch den Förderkanal (7) gegen einen Sollwert durch Variation des Fördergasstroms, **dadurch gekennzeichnet, dass** an einer zwischen Verdampfer (1) und Sensor (8) angeordneten Mischstelle (18) eine einen zweiten Massenflusskontroller (22) aufweisende Ausgleichsgaszuleitung (15) mündet und die Regeleinrichtung (11) eingerichtet ist, den zweiten Massenflusskontroller (22) derart anzusteuern, dass bei der Variation des Fördergasstroms der am Sensor (8) vorbeiströmende Gasstrom konstant bleibt und der Gasstrom mit einer konstanten Strömungsgeschwindigkeit an der Depositionsfläche vorbeiströmt.

3. Verfahren nach Anspruch 1, **dadurch gekennzeichnet, dass** die Summe der mit dem ersten Massenflusskontroller (10) und mit dem zweiten Massenflusskontroller (22) geregelten Massen-Flüsse mit einer Toleranz der Regelgenauigkeit der Massenflusskontroller konstant gehalten wird.

4. Vorrichtung nach Anspruch 2, **gekennzeichnet durch** eine Dosiervorrichtung (12), mit der aus einem Vorrat des Ausgangsmaterials eine abgemessene Menge an den Verdampfer (1) abgebbar ist.

5. Verfahren nach einem der Ansprüche 1 oder 3, **dadurch gekennzeichnet, dass** das Ausgangsmaterial ein organisches Pulver ist.

6. Vorrichtung nach einem der Ansprüche 2 oder 4, **dadurch gekennzeichnet, dass** der Verdampfungskörper (4) ein offenporiger Festkörperschaum ist.

7. Verfahren nach einem der Ansprüche 3 oder 5, **dadurch gekennzeichnet, dass** der Fördergasstrom und der Ausgleichsgasstrom von einer Inertgasquelle bereitgestellt werden.

8. Verfahren nach einem der Ansprüche 1, 3, 5 oder 7, **dadurch gekennzeichnet, dass** mit dem erzeugten Dampf organische Schichten oder OLED-Schichten auf einem Substrat abgeschieden werden.

9. Vorrichtung nach einem der Ansprüche 2, 4 oder 6, **dadurch gekennzeichnet, dass** der Förderkanal (7) in einem Gaseinlassorgan eines Reaktors mündet, der eine Prozesskammer aufweist, in der organische Schichten oder OLED-Schichten auf einem Substrat abgeschieden werden können.

10. Vorrichtung nach Anspruch 4, **dadurch gekennzeichnet, dass** zwischen der Dosiervorrichtung (12) und dem Verdampfer (1) ein Zwischenspeicher (14) zum Zwischenspeichern der abgemessenen Pulvermenge vorgesehen ist.

11. Vorrichtung nach Anspruch 10, **dadurch gekennzeichnet, dass** der Zwischenspeicher (14) einen kalten Bereich (14') aufweist, in dem die mit der Dosiervorrichtung (12) abgemessene Menge des Ausgangsstoffs zwischengespeichert wird, und einen heißen Bereich (14") aufweist, in dem die abgemessene Menge des Pulvers gebracht wird, um durch eine Einspeiseöffnung (5) dem Verdampfer (1) zugeführt zu werden.

12. Verfahren nach einem der Ansprüche 1, 3, 5, 7 oder 8, **dadurch gekennzeichnet, dass** in einer Dosiervorrichtung (12) eine Vorrichtung zur Bereitstellung einer quantifizierten Menge des Ausgangsmaterials angeordnet ist, wobei eine Vielzahl von quantifizierten Mengen zeitlich nacheinander in einem von einer Gaszuleitung (16) bereitgestellten Trägergasfluss gebracht werden, mit dem die quantifizierten Mengen als Aerosol-Fluss zum Zwischenspeicher (14) transportiert werden.

13. Vorrichtung nach Anspruch 4, **dadurch gekennzeichnet, dass** in der Dosiervorrichtung (12) eine Vorrichtung zur Bereitstellung einer quantifizierten Menge des Ausgangsmaterials angeordnet ist.

## Claims

1. A method for vaporizing a non-gaseous starting material, in which the starting material is brought into a vaporization chamber (3) of a vaporizer (1), a vaporization body (4) of the vaporizer (1) supplies heat to the starting material so that it vaporizes to form a vapour, the vapour is transported by means of a conveying gas stream which is fed into the vaporization chamber (3) through a gas supply line (9), the mass flow of which conveying gas stream being controlled by a first mass flow controller (10), through a conveying conduit (7) passing a deposition surface of a QCM sensor (8) which measures the concentration or the partial pressure of the vapour in the gas stream flowing through the conveying conduit (7) in a manner such that the vapour condenses on the deposition surface at a rate which is a function of the partial pressure or the concentration, and the mass flow of the vapour through the conveying conduit (7) is controlled by variation of the conveying gas stream against a nominal value, **characterized in that** a compensating gas stream is fed into the conveying conduit (7) at a mixing point (18) disposed between the vaporizer (1) and sensor (8), the mass flow of which compensating gas stream being controlled by a second mass flow controller (22) in a manner such that when the conveying gas stream varies, the gas stream flowing past the sensor (8) remains constant and flows past the deposition surface at a constant flow rate.

2. A device for vaporizing a non-gaseous starting material, with a vaporizer (1) which has a vaporization chamber (3) and a vaporization body (4) which can be heated, with which the starting material brought into the vaporization chamber (3) is vaporized to form a vapour, with a gas supply line which discharges into the vaporization chamber (3) and has a first mass flow controller for feeding a conveying gas stream into the vaporization chamber (3), with a conveying conduit (7) emanating from the vaporization chamber (3) in order to transport the vapour with the conveying gas stream to a sensor (8) which is a QCM sensor (8) with a deposition surface which is disposed in the conveying conduit (7) and which measures the concentration or the partial pressure of the vapour in the gas stream flowing through the conveying conduit (7) in a manner such that the vapour condenses on the deposition surface at a rate which is a function of the partial pressure or the concentration, and with a control device (11) for controlling the mass flow of the vapour through the conveying conduit (7) against a nominal value by variation of the conveying gas stream, **characterized in that** a compensating gas supply line (15) having a second mass flow controller (22) discharges at a mixing point (18) disposed between the vaporizer (1) and sensor (8) and the control device (11) is configured to control the second mass flow controller (22) in a manner such that when the conveying gas stream varies, the gas stream flowing past the sensor (8) remains constant and the gas stream flows past the deposition surface at a constant flow rate.

3. The method according to claim 1, **characterized in that** the sum of the mass flow controlled with the first mass flow controller (10) and with the second mass flow controller (22) is kept constant within a tolerance of the control accuracy of the mass flow controllers.

4. The device according to claim 2, **characterized by** a metering device (12) with which a measured quantity from a store of the starting material can be dispensed to the vaporizer (1).

5. The method according to one of the claims 1 or 3, **characterized in that** the starting material is an organic powder.

6. The device according to one of the claims 2 or 4, **characterized in that** the vaporization body (4) is an open-pored solid foam.

7. The method according to one of the claims 3 or 5, **characterized in that** the conveying gas stream and the compensating gas stream are provided from one source of inert gas.

8. The method according to one of the claims 1, 3, 5 or 7, **characterized in that** organic layers or OLED layers are deposited onto a substrate with the vapour which is produced.

9. The device according to one of the claims 2, 4 or 6, **characterized in that** the conveying conduit (7) discharges into a gas inlet means of a reactor which has a process chamber in which organic layers or OLED layers can be deposited on a substrate.

10. The device according to claim 4, **characterized in that** an intermediate reservoir (14) for the intermediate storage of the measured quantity of powder is provided between the metering device (12) and the vaporizer (1).

11. The device according to claim 10, **characterized in that** the intermediate reservoir (14) has a cold region (14') in which the quantity of the starting substance measured with the metering device (12) is temporarily stored, and a hot region (14") into which the measured quantity of the powder is brought in order to be supplied to the vaporizer (1) through the infeed opening (5).

12. The method according to one of the claims 1, 3, 5, 7 or 8, **characterized in that** a device for providing a quantified quantity of the starting material is disposed in the metering device (12), wherein a plurality of quantified quantities are brought temporally one after the other into a carrier gas flow provided from a gas supply line (16), with which the quantified quantities are transported to the intermediate reservoir (14) as an aerosol flow.

13. The device according to claim 4, **characterized in that** a device for providing a quantified quantity of the starting material is disposed in the metering device (12).

## Revendications

1. Procédé pour l'évaporation d'une matière initiale gazeuse, pour lequel la matière initiale est placée dans une chambre d'évaporation (3) d'un évaporateur (1), un corps d'évaporation (4) de l'évaporateur (1) apporte de la chaleur à la matière initiale de telle manière qu'elle s'évapore en une vapeur, la vapeur est transportée par un conduit de transport (7) sur une surface de déposition d'un capteur MCQ (à microbalance à cristaux de quartz) (8) au moyen d'un flux gazeux de transport introduit dans la chambre d'évaporation (3) par une conduite d'alimentation de gaz (9), dont le débit de masse est régulé par un premier contrôleur de débit de masse (10), qui mesure la concentration ou la pression partielle de la vapeur dans le flux de gaz s'écoulant par le conduit de transport (7) de telle manière que la vapeur est condensée sur la surface de déposition dans un taux dépendant de la pression partielle ou de la concentration et le débit de masse de la vapeur est régulé par le conduit de transport (7) par la variation du débit de gaz de transport par rapport à une valeur seuil, **caractérisé en ce qu'**un flux de gaz d'équilibre est introduit dans le conduit de transport (7) à un point de mélange (18) disposé entre l'évaporateur (1) et le capteur (8), dont le débit de masse est régulé par un deuxième contrôleur de débit de masse (22) de telle sorte que lors de la variation du flux de gaz de transport le flux de gaz passant au capteur (8) reste constant et passe sur la surface de déposition avec une vitesse d'écoulement constante.

2. Dispositif pour l'évaporation d'une matière initiale non gazeuse, avec un évaporateur (1), qui comporte une chambre d'évaporation (3) et un corps d'évaporation (4) pouvant être chauffé, avec lequel la matière initiale placée dans la chambre d'évaporation (3) est évaporée en une vapeur, avec une conduite d'alimentation de gaz débouchant dans la chambre d'évaporation (3), comportant un premier contrôleur de débit de masse pour introduire un flux de gaz de transport dans la chambre d'évaporation (3) avec un conduit de transport (7) sortant de la chambre d'évaporation (3) pour le transport de la vapeur avec le flux de gaz de transport sur un capteur (8) disposé dans le conduit de transport (7), un capteur MCQ (à microbalance à cristaux de quartz) (8) comportant une surface de déposition, qui mesure la concentration ou la pression partielle de la vapeur dans le flux de gaz s'écoulant par le conduit de transport (7) de telle manière que la vapeur est condensée sur la surface de déposition à un taux dépendant de la pression partielle ou de la concentration et avec un système de régulation (11) pour la régulation du débit de masse de la vapeur à travers le conduit de transport (7) par rapport à une valeur seuil par la variation du flux de gaz de transport, **caractérisé en ce qu'**une conduite d'alimentation de gaz d'équilibre (15) comportant un deuxième contrôleur de débit de masse (22) débouche à un point de mélange (18) disposé entre l'évaporateur (1) et le capteur (8) et le système de régulation (11) est agencé pour activer le deuxième contrôleur de débit de masse (22) de telle manière que lors de la variation du flux de gaz de transport, le débit de gaz passant au capteur (8) reste constant et le débit de gaz s'écoule en passant avec une vitesse d'écoulement constante sur la surface de déposition.

3. Procédé selon la revendication 1, **caractérisé en ce que** le total des débits de masse régulés avec le premier contrôleur de débit de masse (10) et le deuxième contrôleur de débit de masse (22) est maintenu constant avec une tolérance de précision de régulation des contrôleurs de débit de masse.

4. Dispositif selon la revendication 2, **caractérisé par** un dispositif de dosage (12) avec lequel une quantité mesurée peut être déposée sur l'évaporateur (1) à partir d'une réserve de matière initiale.

5. Procédé selon l'une quelconque des revendications 1 ou 3, **caractérisé en ce que** la matière initiale est une poudre organique.

6. Dispositif selon l'une quelconque des revendications 2 ou 4, **caractérisé en ce que** le corps d'évaporation (4) est une mousse de corps solides à pores ouverts.

7. Procédé selon l'une quelconque des revendications 3 ou 5, **caractérisé en ce que** le flux de gaz de transport et le flux de gaz d'équilibrage sont produits par une source de gaz inerte.

8. Procédé selon l'une quelconque des revendications 1, 3, 5 ou 7, **caractérisé en ce que** des couches organiques ou couches DELO (à diodes électroluminescentes organiques) sont déposées sur un substrat.

9. Dispositif selon l'une quelconque des revendications 2, 4 ou 6, **caractérisé en ce que** le conduit de transport (7) débouche dans un organe d'admission de gaz d'un réacteur, qui comporte une chambre de traitement dans laquelle des couches organiques ou couches DELO (à diodes électroluminescentes organiques) peuvent être déposées sur un substrat.

10. Dispositif selon la revendication 4, **caractérisé en ce qu'**un accumulateur intermédiaire (14) pour emmagasiner provisoirement la quantité de poudre mesurée est prévu entre le dispositif de dosage (12) et l'évaporateur (1).

11. Dispositif selon la revendication 10, **caractérisé en ce que** l'accumulateur intermédiaire (14) comporte une zone froide (14'), dans laquelle la quantité mesurée de matière initiale avec le dispositif de dosage (12) est emmagasinée provisoirement et comporte une zone chaude (14"), dans laquelle la quantité mesurée de poudre est placée pour être acheminée à l'évaporateur (1) par une ouverture d'alimentation (5).

12. Procédé selon l'une quelconque des revendications 1, 3, 5, 7 ou 8, **caractérisé en ce qu'**un dispositif de préparation d'une quantité quantifiée de matière initiale est disposé dans le dispositif de dosage (12), sachant que des quantités quantifiées de matière initiale sont placées en grand nombre en fonction du temps les unes derrière les autres dans un flux de gaz porteur produit par une conduite d'alimentation de gaz (16) avec lequel les quantités quantifiées sont transportées en tant que flux aérosol vers l'accumulateur intermédiaire (14).

13. Dispositif selon la revendication 4, **caractérisé en ce qu'**un dispositif de préparation d'une quantité quantifiée de matière initiale est disposé dans le dispositif de dosage (12).
